Europäisches Patentamt

(19) European Patent Office

Office européen des brevets

(11) Numéro de publication: **0 124 424**
**B1**

(12) **FASCICULE DE BREVET EUROPEEN**

(45) Date de publication du fascicule du brevet:
08.02.89

(21) Numéro de dépôt: **84400798.9**

(22) Date de dépôt: **19.04.84**

(51) Int. Cl.⁴: **H 05 K 7/10,** H 05 K 3/30,
H 05 K 3/34

(54) Picot de support de fixation de composant électronique sur circuit imprimé et comportant ces picots.

(30) Priorité: **29.04.83 FR 8307182**

(43) Date de publication de la demande:
**07.11.84 Bulletin 84/45**

(45) Mention de la délivrance du brevet:
**08.02.89 Bulletin 89/6**

(84) Etats contractants désignés:
**BE DE GB**

(56) Documents cités:
**FR-A- 1 315 948**
**FR-A- 1 521 180**
**US-A- 3 861 030**
**US-A- 4 060 296**

**IBM TECHNICAL DISCLOSURE BULLETIN, vol. 21, no. 12, mai 1979, New York (US) R.E. DARROW et al.:"Substrate pinning process using a pressed tapered pin", pages 4798-4799**

(73) Titulaire: **THOMSON-CSF, 173, Boulevard Haussmann, F-75379 Paris Cédex 08 (FR)**

(72) Inventeur: **Biraud, Lucien, THOMSON-CSF SCPI 173, bld Haussmann, F-75379 Paris Cedex 08 (FR)**

(74) Mandataire: **Benoit, Monique et al, THOMSON-CSF SCPI 19, avenue de Messine, F-75008 Paris (FR)**

## Description

La présente invention concerne la fixation de composant électronique sur circuit imprimé et plus particulièrement des picots de support de fixation de composant électronique sur circuit imprimé et un support comportant ces picots.

Le brevet FR-A 1 315 948 décrit une cosse de connection permettant d'introduire simultanément deux terminaisons de fils, une sur chacune de ses faces. La cosse a une structure ouverte. Les fils peuvent être soudés sur les terminaisons de fils.

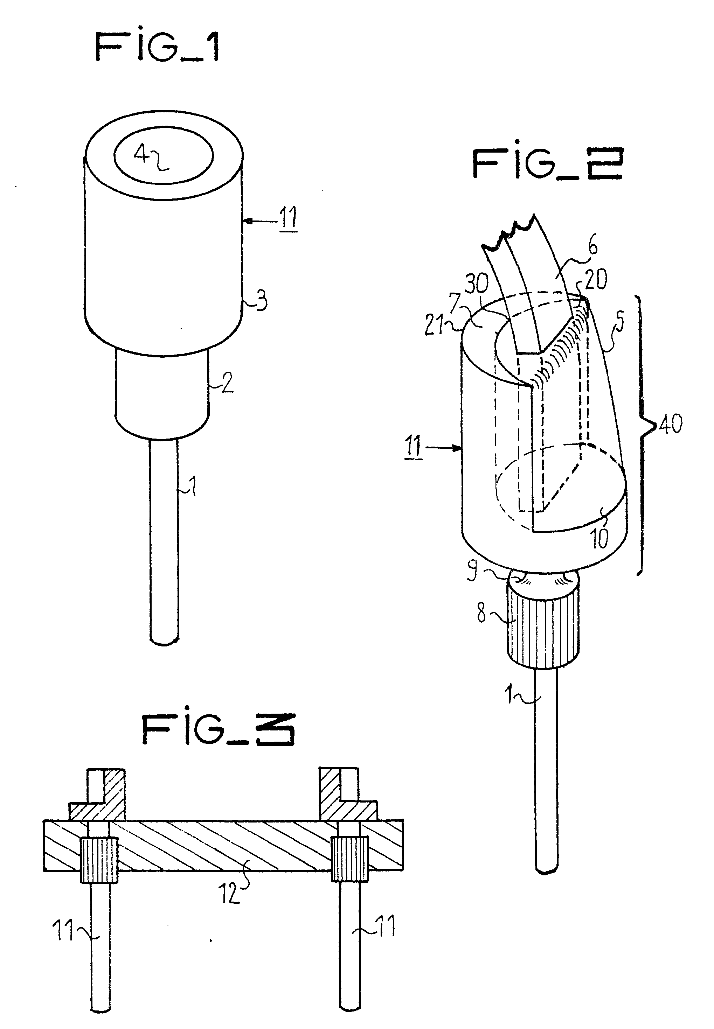

Certains composants doivent être changés durant la vie du circuit imprimé, soit par suite d'une défaillance, soit pour des raisons liées au développement des matériels. Ainsi quand un programme plus élaboré a été mis au point, on remplace souvent les mémoires mortes de type PROM contenant ces programmes. Les mémoires PROM sont des mémoires que l'on ne peut programmer qu'une fois. L'instruction du programme ou la donnée stockée ne peut plus être modifiée à volonté. Or des soudages et des dessoudages successifs nuisent à la fiabilité des circuits imprimés. Les circuits imprimés double face, et les circuits imprimés multicouche sont les plus fragiles à une élévation de température. On a donc été amené à utiliser des supports intermédiaires assurant la fixation d'un composant électronique sur circuit imprimé. Habituellement le support est soudé sur un circuit imprimé. Il est connu d'utiliser deux types de support pour assurer la fixation des circuits intégrés sur des circuits imprimés. Un premier type de support qui permet l'enfichage de circuits intégrés et qui présente l'avantage d'un remplacement aisé de ces circuits intégrés sans dessoudage ni soudage. Toutefois, en présence de vibrations, des connexions électriques support-circuit intégré risquent d'être interrompues. Ce type de coupures, même si elles ne durent qu'un temps extrêmement bref, sont très graves pour les circuits numériques. En cas d'emploi de circuits logiques, l'état logique à la suite de ces coupures est quelconque. D'autre part le support pour enfichage du circuit intégré du type connu présente un encombrement vertical important qui est nécessaire pour permettre l'enfichage. Un second type de support qui permet la soudure des circuits intégrés du type connu est constitué par des plots en matériau conducteur représentés sur la figure 1, reliés par une plaquette en matériau isolant. Comme il est expliqué ci-dessous, ce type de support présente des difficultés pour dessouder les circuits intégrés qu'il supporte.

Le Brevet US-A-4 060 296 décrit un support pour circuit intégré de type DIL comportant des picots dont la partie supérieure est ouverte. Ce support permet une fixation de circuit intégré, par élasticité des picots, sans soudure.

Le support selon l'invention comporte des plots semi-ouverts, permettant une fixation sûre du circuit intégré par l'utilisation de soudure, et un dessoudage aisé.

L'invention a principalement pour objet un picot pour un support permettant de fixer un composant électronique sur un circuit imprimé, ledit picot comportant un plot assurant la fixation du support et la connexion électrique d'une patte du composant électronique au circuit imprimé, une base et une butée susceptibles de positionner la patte du composant caractérisé en ce que la butée comporte une face concave destinée à recevoir la patte et en ce que le côté opposé à ladite face est ouvert de manière à permettre un soudage et un dessoudage aisés de la patte du composant.

L'invention sera mieux comprise au moyen de la description ci-après et des figures annexées données comme des exemples non limitatifs parmi lesquels:

la figure 1: est une vue en perspective d'un picot de support de circuit intégré de type connu.

La figure 2: est une vue en perspective d'une variante de réalisation d'un picot de support des composants électronique selon l'invention.

La figure 3: est une vue en coupe une variante des réalisations du support selon l'invention.

La figure 4: est une vue en perspective d'une autre variante de réalisation du support selon l'invention.

La figure 5: est une vue en coupe d'un support monté sur un circuit imprimé équipé d'un circuit intégré.

La figure 6: est une vue en perspective d'une seconde variante de réalisation d'un picot de support des composants électroniques selon l'invention.

Sur la figure 1, on peut voir un picot de support de type connu pour circuit intégré. Le support est constitué par une plaquette en matière isolante non représentée sur la figure, positionnant les picots avec les mêmes écartements que les pattes du circuit intégré à la fixation duquel ledit support est dessiné.

Le picot 11 comporte un plot à souder 1 sur un circuit imprimé.

Une épaulement 2 ménage un espace entre le circuit imprimé et les supports de circuit intégré. La partie cylindrique 3 permet la fixation du picot dans la plaquette. Le picot 11 présente dans sa partie supérieure un évidement 4, destiné à recevoir une patte de connexion du circuit intégré. Une fois la patte introduite dans les évidements 4 du picot 11, on procède à la soudure permettant la fixation fiable du circuit intégré. Pour dessouder le circuit intégré de ce type de supports, on est obligé de dessouder toutes les pattes en même temps. Si on essaye de dessouder une seule patte, comme d'une part on ne peut pas l'enlever quand la soudure est fluide, car la patte reste solidaire du circuit intégré qui est toujours fixé par les autres pattes et d'autre part, l'évidement 4 étant fermé, on ne peut pas aspirer toute la soudure, la patte reste soudée à son support. Dessouder toutes les pattes en même temps nécessite un matériel spécial.

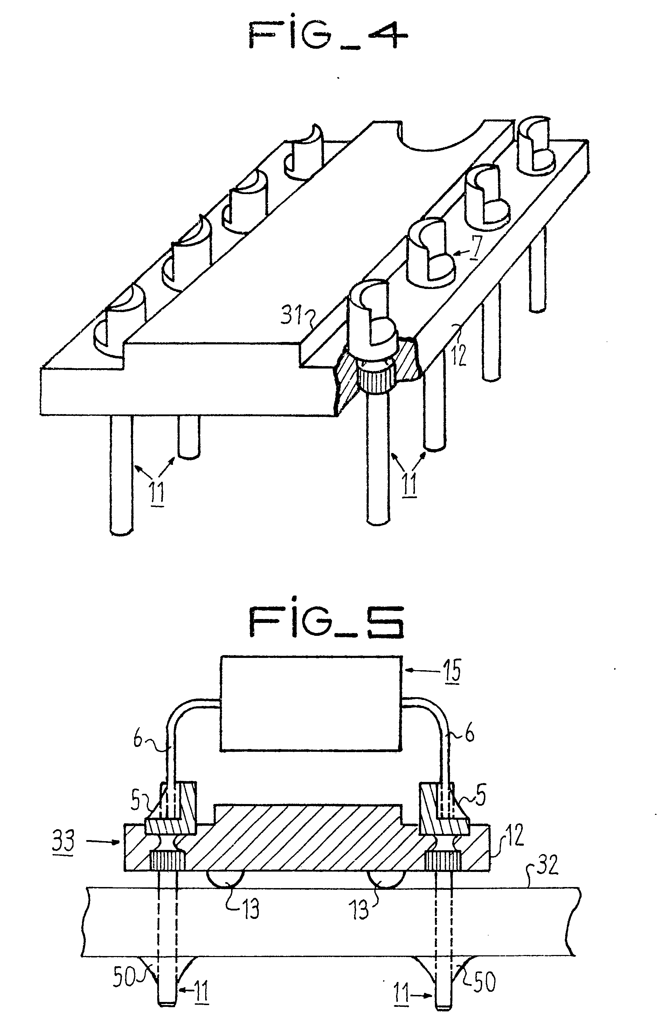

Sur la figure 2, on peut voir un picot 11 de support de composant électronique selon l'invention. Le picot 11 est métallique. Le picot 11 comporte une butée 7 et une base 10 sur lesquelles vient prendre appui une patte 6 par exemple d'un circuit intégré. Une face 20 de la butée 7 destinée à recevoir la patte 6 est concave.

Ainsi, la partie 40 du picot 11, destinée à recevoir la patte 6, est ouverte sur le côté opposé à la butée 7. Avantageusement la face 20 est un cylindre à base elliptique ou circulaire.

Une goutte de soudure 5 prend place entre la paroi 20 et la base 10. Dans l'exemple de réalisation de la figure 2, la face externe de la butée 7 est cylindrique. Une partie cylindrique 8 permet la fixation du picot 11 dans la plaquette. Avantageusement la partie cylindrique 8 comporte des rainures verticales assurant une meilleure fixation du picot 11 dans la plaquette. Avantageusement le picot 11 comporte entre la base 10 et la partie cylindrique 8 un rétrécissement 9. Le rétrécissement 9 permet de limiter le transfert de chaleur vers le circuit imprimé. La fixation sur le circuit imprimé du support est assurée par un plot 1. Avantageusement le plot 1 a un diamètre standard de composants électroniques pour pouvoir s'adapter par exemple à un trou standard de diamètre de 0,85 mm.

Sur la figure 3, on peut voir un premier exemple de réalisation du support selon l'invention. Ce support comporte deux rangés de picots 11 fixés dans une plaquette 12 parallélépipède rectangle. Le support selon l'invention comporte un nombre de picots 11 au moins égal au nombre des pattes 6 du composant électronique à fixer. Avantageusement la plaquette 12 dans laquelle sont fixés les picots 11 est réalisée dans une résine thermodurcissable. Ainsi elle présente une bonne résistance à l'humidité, au changement de température et au solvant. Avantageusement les picots 11 sont noyés dans une matière constituant la plaquette 12. La position des picots 11 est choisie de telle façon qu'un circuit intégré à souder tient sur son support même avant l'opération de soudage. Avantageusement les pattes du circuit intégré sont écartées et tiennent par élasticité en prenant appui sur le bord 30 de la face 20 du picot 11 de la figure 2. Ainsi les bornes 6 ne prennent pas appui sur toute la hauteur de la face 20 ce qui facilite le dessoudage et l'aspiration de la soudure.

Sur la figure 4 on peut voir un second exemple de réalisation du support selon l'invention. La plaquette 12 comporte un renforcement 31 entre les deux rangées de picots 11 qui n'augmente pas l'encombrement vertical du support.

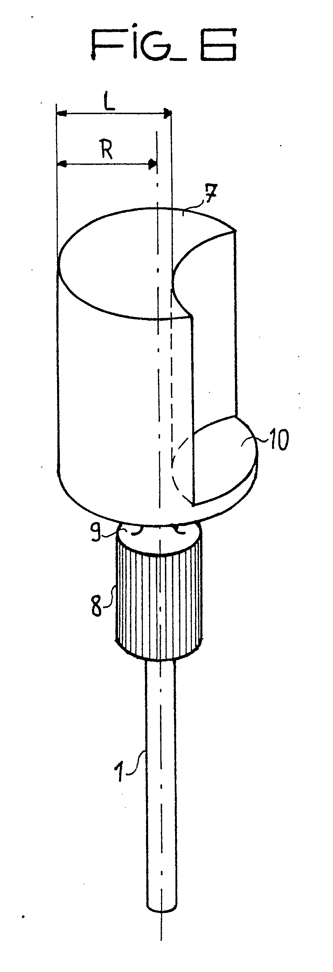

Sur la figure 5, on peut voir un support 33 selon l'invention portant un circuit intégré 15 à deux rangées de pattes (appelée DUAL IN LINE). Le support 33 est fixé sur un circuit imprimé 32 par les picots 11 qui traversent le circuit imprimé auquel ils sont soudés par la soudure 50. Des bossages 13 ménagent un espace entre le support et un circuit imprimé. Cet espace permet notamment le nettoyage du circuit imprimé.

Le support selon l'invention permet une fixation sûre sans coupure de courant électrique dans les conditions de températures pouvant varier de −55° à +125°C. De même les connexions électriques ont été assurées en soumettant le circuit imprimé équipé d'un support selon l'invention comportant un circuit intégré à une accélération sinusoïdale d'amplitude 981 m s$^{-2}$ et dont on a fait varier la fréquence entre 10 et 2000 Hz.

Les performances du support selon l'invention permetent de l'utiliser dans des conditions très difficiles comme par exemple dans les équipements électroniques d'avions ou de missiles.

Sur la figure 6, on peut voir un picot 11 selon l'invention comportant une butée 7 de largeur L R, R étant le rayon de la base 10 du picot 11. Ainsi, un support comportant des picots 11 de même écartement que celui des pattes du composant électronique à fixer maitient par élasticité ce composant avant l'opération de soudure. Ceci permet d'utiliser le support selon l'invention sur les circuits imprimés existant, comportant un écartement des trous correspondant à l'écartement des pattes du composant électronique.

L'invention n'est pas limitée au support pour circuit intégré. Les supports pour tous composants électroniques comme par exemple des transistors, des diodes, des transformateurs, des ponts redresseurs, des résistances, des condensateurs, ou des piles ne sortent pas du cadre de la présente invention.

**Revendications**

1. Picot (11) pour un support (33) permettant de fixer un composant électronique sur un circuit imprimé, ledit picot comportant un plot (1) assurant la fixation du support et la connexion électrique d'une patte (6) du composant électronique au circuit imprimé (32), une base (10) et une butée (7) susceptibles de positionner la patte du composant, caractérisé en ce que la butée comporte une face (20) concave destinée à recevoir la patte et en ce que le côté opposé à ladite face est ouvert de manière à permettre un soudage et un dessoudage aisés de la patte du composant.

2. Picot (11) selon la revendication 1, caractérisé par le fait qu'il comporte un rétrécissement (9) situé entre la base (10) destinée à recevoir la patte (6) du composant électronique et le plot (1).

3. Picot (11) selon l'une quelconque des revendications 1 ou 2, caractérisé par le fait que la largeur L de la butée (7) est supérieure au rayon R de la base (10) du picot (11).

4. Support pour composant électronique caractérisé par le fait qu'il comporte des picots (11) selon l'une quelconque des revendications précédentes.

5. Support selon la revendication 4, caractérisé par le fait qu'il comporte une plaquette (12) en résine thermo-durcissable dans laquelle sont noyés les picots (11).

6. Support selon la revendication 4 ou 5, caractérisé par les faits qu'il comporte des bossages (13) permettant de ménager un espace entre les supports et le circuit imprimé (32).

7. Support selon une quelconque des revendications 4, 5 ou 6, caractérisé par le fait que les picots (11) sont disposés avec un écartement supérieur à celui des pattes (6) du composant électronique à fixer, de sorte que le composant électronique tient par élasticité sur le support avant l'opération de soudure.

8. Utilisation d'un support selon une quelconque des revendications 4, 5, 6 ou 7, caractérisé par le fait que le composant électronique que le support permet de fixer est un circuit intégré.

9. Utilisation d'un support selon une quelconque des revendications 4, 5, 6 ou 7, caractérisé par le fait que le composant électronique que le support permet de fixer est un circuit intégré à deux rangés de pattes dit DUAL IN LINE.

## Claims

1. A mounting pin (11) for a support (33) allowing to fix an electronic component onto a printed circuit, said mounting pin comprising a stud (1) for fixing the support and electrically connecting a tab (6) of the electronic component to the printed circuit (32), a base (10) and an abutment (7) susceptible of positioning the tab of the component, characterized in that the abutment comprises a concave face (20) intended to receive the tab, and that the side opposite to said face is open so as to allow for easy soldering and unsoldering of the tab of the component.

2. A mounting pin (11) according to claim 1, characterized in that it comprises a constriction (9) between the base (10) intended to receive the tab (6) of the electronic component and the stud (1).

3. A mounting pin (11) according to claim 1, characterized in that the width L of the abutment (7) is greater than the diameter R of the base (10) of the mounting pin.

4. A support for an electronic component, characterized in that it comprises mounting pins (11) according to any one of the preceding claims.

5. A support according to claim 4, characterized in that it comprises a plate (12) of thermohardening resin, in which the mounting pins (11) are embedded.

6. A support according to claim 4 or 5, characterized in that it comprises bosses (13) allowing to provide for a distance between the supports and the printed circuit (32).

7. A support according to any one of claims 4, 5 or 6, characterized in that the mounting pins (11) are arranged at distances exceeding those of the tabs (6) of the electronic component to be fixed, such that the electronic component keeps footing by virtue of elasticity prior to being soldered.

8. The use of a support according to any one of claims 4, 5, 6 or 7, characterized in that the electronic component, which the support is adapted to fix, is a printed circuit.

9. The use of a support according to any one of claims 4, 5, 6 or 7, characterized in that the electronic component, which the support is adapted to fix, is a printed circuit having two tab rows, named DUAL IN LINE.

## Patentansprüche

1. Kontaktstütze (11) für einen Träger (33) zur Befestigung eines elektronischen Bauteils auf einer gedruckten Schaltung, wobei die Kontaktstütze einen Stift (1) zur Befestigung des Trägers und zur elektrischen Verbindung eines Anschlussfusses (6) des elektronischen Bauteils an der gedruckten Schaltung (32), eine Basis (10) und einen Anschlag (7) aufweist, welch letztere den Anschlussfuss des Bauteils zu positionieren gestatten, dadurch gekennzeichnet, dass der Anschlag eine konkave Fläche (20) zur Aufnahme des Anschlussfusses aufweist, und dass die Gegenseite dieser Fläche offen ist, so dass ein bequemes Anlöten und Ablöten des Anschlussfusses des Bauteils möglich ist.

2. Kontaktstütze (11) nach Anspruch 1, dadurch gekennzeichnet, dass sie eine Einschnürung (9) zwischen der Basis (10) zur Aufnahme des Anschlussfusses (6) des elektronischen Bauteils und dem Stift (1) besitzt.

3. Kontaktstütze (11) nach einem der Ansprüche 1 oder 2, dadurch gekennzeichnet, dass die Breite L des Anschlages (7) grösser als der Radius R der Basis (10) der Kontaktstütze (11) ist.

4. Träger für ein elektronisches Bauteil, dadurch gekennzeichnet, dass er Kontaktstützen gemäss einem der vorhergehenden Ansprüche aufweist.

5. Träger nach Anspruch 4, dadurch gekennzeichnet, dass er eine Platte (12) aus wärmehärtbarem Harz besitzt, in welcher die Kontaktstützen (11) eingesenkt sind.

6. Träger nach Anspruch 4 oder 5, dadurch gekennzeichnet, dass er Buckel (13) aufweist, mit deren Hilfe ein Abstand zwischen den Trägern und der gedruckten Schaltung (32) hergestellt wird.

7. Träger nach einem beliebigen der Ansprüche 4, 5 oder 6, dadurch gekennzeichnet, dass die Kontaktstützen (11) mit einem Abstand angeordnet sind, der grösser als der der Anschlussfüsse des zu befestigenden elektronischen Bauteils ist, derart, dass sich das elektronische Bauteil vor dem Löten durch Federwirkung auf dem Träger hält.

8. Verwendung eines Trägers nach einem der Ansprüche 4, 5, 6 oder 7, dadurch gekennzeichnet, dass das elektronische Bauteil, welches der Träger zu befestigen gestattet, ein integrierter Schaltkreis ist.

9. Verwendung eines Trägers nach einem der Ansprüche 4, 5, 6 oder 7, dadurch gekennzeichnet, dass das elektronische Bauteil, welches der Träger zu befestigen gestattet, ein integrierter Schaltkreis mit Reihen von Kontaktstützen, genannt DUAL IN LINE, ist.

## FiG_1

## FiG_2

## FiG_3

# FIG_4

# FIG_5

# FIG_6